(19) Europäisches Patentamt
European Patent Office
Office européen des brevets

(11) **EP 1 456 840 B1**

(12) **EUROPEAN PATENT SPECIFICATION**

(45) Date of publication and mention
of the grant of the patent:
**20.02.2008 Bulletin 2008/08**

(51) Int Cl.:
***G11B 7/0065*** (2006.01)

(21) Application number: **01994836.3**

(22) Date of filing: **07.12.2001**

(86) International application number:
**PCT/EP2001/015421**

(87) International publication number:
**WO 2003/049092 (12.06.2003 Gazette 2003/24)**

(54) **A SOLID STATE MICROOPTICAL ELECTROMECHANICAL SYSTEM (MOEMS) FOR READING A PHOTONICS DIFFRACTIVE MEMORY**

AUS FESTKÖRPER GEBILDETES MIKROOPTISCHES ELEKTROMECHANISCHES SYSTEM (MOEMS) ZUR WIEDERGABE EINES PHOTONISCHEN DIFFRAKTIVEN SPEICHERS

SYSTEME ELECTROMECANIQUE MICRO-OPTIQUE A L'ETAT SOLIDE POUR LECTURE D'UNE MEMOIRE A DIFFRACTION PHOTONIQUE

(84) Designated Contracting States:
**AT BE CH CY DE DK ES FI FR GB GR IE IT LI LU MC NL PT SE TR**

(43) Date of publication of application:
**15.09.2004 Bulletin 2004/38**

(73) Proprietor: **Research Investment Network, Inc Irvine, CA 92614 (US)**

(72) Inventors:
• **KIEFER, Renaud**
**F-67800 Hoenheim (FR)**
• **EL HAFIDI, Idriss**
**F-67100 strasbourg (FR)**
• **TAKAKURA, Yoshitate**
**F-67400 Illkirch (FR)**
• **FONTAINE, Joel**
**F-67200 Strasbourg (FR)**
• **GRZYMALA, Romualda**
**F-67000 Strasbourg (FR)**
• **MEYRUEIS, Patrick**
**F-67000 Strasbourg (FR)**

(74) Representative: **Hirsch & Associés**
**58, avenue Marceau**
**75008 Paris (FR)**

(56) References cited:
**US-A- 5 436 867          US-A- 5 959 747**
**US-A- 6 055 174**

• **PATENT ABSTRACTS OF JAPAN vol. 1999, no. 04, 30 April 1999 (1999-04-30) -& JP 11 016375 A (TOSHIBA CORP), 22 January 1999 (1999-01-22)**
• **MILLER R A ET AL: "MICROMACHINED ELECTROMAGNETIC SCANNING MIRRORS" OPTICAL ENGINEERING, SOC. OF PHOTO-OPTICAL INSTRUMENTATION ENGINEERS. BELLINGHAM, US, vol. 36, no. 5, 1 May 1997 (1997-05-01), pages 1399-1407, XP000692371 ISSN: 0091-3286**
• **LAKNER H ET AL: "MICROMIRRORS FOR DIRECT WRITING SYSTEMS AND SCANNERS" PROCEEDINGS OF THE SPIE, SPIE, BELLINGHAM, VA, US, no. 3878, 20 September 1999 (1999-09-20), pages 217-227, XP008002284 cited in the application**

## Description

### FIELD OF THE INVENTION

The present invention generally relates to a photonics diffractive memory. In particular, the present invention relates to an apparatus for reading information from the photonics diffractive memory.

### BACKGROUND OF THE INVENTION

The large storage capacities and relative low costs of CD-ROMS and DVDs have created an even greater demand for still larger and cheaper optical storage media. Holographic memories have been proposed to supersede the optical disc as a high-capacity digital storage medium. The high density and speed of the holographic memory comes from three-dimensional recording and from the simultaneous readout of an entire packet of data at one time. The principal advantages of holographic memory are a higher information density (10" bits or more per square centimeter), a short random access time (~ 100 microseconds and less), and a high information transmission rate ($10^9$ bit/sec).

In holographic recording, a light beam from a coherent monochromatic source (e.g., a laser) is split into a reference beam and an object beam. The object beam is passed through a spatial light modulator (SLM) and then into a storage medium. The SLM forms a matrix of shutters that represents a packet of binary data. The object beam passes through the SLM which acts to modulate the object beam with the binary information being displayed on the SLM. The modulated object beam is then directed to one point on the storage medium by an addressing mechanism where it intersects with the reference beam to create a hologram representing the packet of data.

An optical system consisting of lenses and mirrors is used to precisely direct the optical beam encoded with the packet of data to the particular addressed area of the storage medium. Optimum use of the capacity of a thick storage medium is realized by spatial and angular multiplexing. In spatial multiplexing, a set of packets is stored in the storage medium shaped into a plane as an array of spatially separated and regularly arranged subholograms by varying the beam direction in the x-axis and y-axis of the plane. Each subhologram is formed at a point in the storage medium with the rectangular coordinates representing the respective packet address as recorded in the storage medium. In angular multiplexing, recording is carried out by keeping the x- and y- coordinates the same while changing the irradiation angle of the reference beam in the storage medium. By repeatedly incrementing the irradiation angle, a plurality of packets of information is recorded as a set of subholograms at the same x- and y- spatial location.

Previous holographic devices for recording information in a highly multiplexed volume holographic memory, and for reading the information out, require components and dimensions having a large size which places a limit on the ability to miniaturize these systems. Because previous holographic devices use motors and large-scale components such as mirrors and lenses, the addressing systems of these previous devices are slow. Furthermore, the mechanical components of these previous devices need frequent maintenance to correct errors and dysfunction coming, for instance, from wear and friction (i.e., tribology effect). Furthermore, previous addressing systems are expensive because they use complex systems for control. Thus, their prices cannot be lowered by mass production. Moreover, previous devices are not economical in their energy consumption. Even when previous addressing devices are accurate when new, the wear and friction of the interacting surfaces that are in relative motion lowers their accuracy with time.

In view of the foregoing, it would be desirable to provide one or more techniques which overcomes the above-described inadequacies and shortcomings of the above-described proposed solutions.

US 5436867 discloses a spatial multiplexer for use with a holographic storage medium. The spatial multiplexer includes an array of discrete reflector elements having a linear shape and disposed in a parallel arrangement with one another upon a substrate, each one having a different angular orientation with respect to the storage medium. An acoustooptic device steers the reference beam vertically to one of the discrete reflector elements for spatial multiplexing. Another acoustooptic device steers the reference beam horizontally for angular multiplexing.

JP 11 016375 discloses a hologram memory device having rows of micromirrors. An object light and a reference light are guided to the same position of a hologram recording medium by displaced micromirrors.

Millimeter-sized analog scanning mirrors capable of delivering deflection angles of more than 60° are described by Miller et al. in "Micromachined electromagnetic scanning mirrors", Opt. Eng. 36(5) pp.1399-1407 (1997). The use of these mirrors is manifested in a holographic data storage system.

Different types of deformable mirror spatial light modulators are disclosed in Lakner et al. in "Micromirrors for direct writing systems and scanners", SPIE vol. 3878, pp.217-227 (1999). For the angular deflection of light a resonant microscanner mirror based on a silicon micromechanical torsional actuator is disclosed.

### OBJECTS OF THE INVENTION

In view of the foregoing, it is an object of the present invention to provide an improvement in higher speed and smaller size of photonics diffractive memory reading systems.

It is a further object of the present invention to provide a miniaturization of a photonics diffractive memory reading system.

It is another object of the present invention to reduce the addressing system of a photonics diffractive memory reading system to a matchbox size.

It is a still a further object of the present invention to design a solid state reading system that can be rapidly manufactured in large quantities and low cost out of existing resources.

## SUMMARY OF THE INVENTION

In order to achieve the above-mentioned objectives, the present invention comprises a solid-state system for reading information from a photonics diffractive memory. A coherent light source generates a convergent light beam which is then deflected by an acousto-optic deflector. A plurality of micro-mirrors receives the deflected light beam from the acousto-optic deflector at one of the micro-mirrors. A photonics diffractive memory having a plurality of points receives at one of the points the reflected light beam which is reflected from the micro-mirror. A detector has a plurality of light-detecting cells. At least one of the cells receives a portion of the reflected light beam transmitted through the point.

In a further aspect of the present invention, the micro-mirrors are configured as a matrix.

In another aspect of the present invention, there is a lens which forms the convergent light beam from the light source.

In still another aspect of the present invention, the convergent light source is selected from the group consisting of a low power laser and a light-emitting diode.

In yet another aspect of the present invention, the detector is a CCD detector array.

In a further aspect of the present invention, each of the plurality of points stores one or more diffraction patterns.

In yet another aspect of the present invention, the photonics diffractive memory comprises stored therein information located at the plurality of points of the memory and at a plurality of angles at each one of the points so as to form a plurality of packets of information at each one of the points.

In another aspect of the present invention, each of the micro-mirrors is a oscillatory scanning micro-mirror.

In a further aspect of the present invention, a computer is configured to coordinate the synchronization of the acousto-optic deflector and the oscillatory micro-mirrors so that the reflected light beam is directed to one of the points with a specific angle for a sufficient time to retrieve information from the point.

In yet another aspect of the present invention, each of the micro-mirrors is a oscillatory micro-mirror and the oscillation cycle of the micro-mirror is coordinated with the scanning of the acousto-optical deflector so as to direct said reflected light beam onto one of the points of the storage medium.

## BRIEF DESCRIPTION OF THE DRAWINGS

In order to facilitate a fuller understanding of the present invention, reference is now made to the appended drawings. These drawings should not be construed as limiting the present invention, but are intended to be exemplary only.

FIG. 1 shows a micro-mirror assembly according to the present invention.
FIG. 2 shows a perspective view of a micro-mirror assembly according to the present invention.
FIG. 2a shows a close up view of the actuator of the micro-mirror assembly according to the present invention.
FIG. 3a shows adding an epitaxial layer to a wafer as part of the MEMS fabrication process according to the present invention.
FIG. 3b shows the formation of the starting electrodes and deposition of a metal layer as part of the MEMS fabrication process according to the present invention.
FIG. 3c shows an anisotropical etch to remove the substrate underneath the designed mirror plate as part of the MEMS fabrication process according to the present invention.
FIG. 3d shows a cross section of the micro-mirror chip according to the present invention.
FIG. 4a shows a starting electrode of a micro-mirror assembly according to the present invention.
FIG. 4b shows operation of a micro-mirror being driven by a saw tooth signal according to the present invention.
FIG. 5 shows a solid state reading system according to the present invention.
FIG. 6 shows an acousto-optic deflector according to the present invention.
FIG. 7 shows a schematic representation of a diffractive optics recording process
FIG. 8 shows a matrix of points forming a storage medium according to the present invention.
FIG. 9 shows synchronization of the mirror of the solid state reading system according to the present invention.

## DETAILED DESCRIPTION OF THE INVENTION

The compact architecture for diffractive optics systems in accordance with the present invention integrates a number of components into a compact package, including an acousto-optic deflector and a microoptoelectromechanical system (MOEMS) device which reduces the addressing component of a reading system for a photonics diffractive memory to a matchbox size. The reading system is made of solid-state components. The mirrors are built in CMOS technology resulting in the advantage that the reading system can be mass-produced at low cost.

Various diffractive recording/reading processes have been developed in the art and further details can be found in the book Holographic Data Storage, Springer (2000) edited by H.J. Coufal, D. Psaltis, and G.T. Sincerbox. In this specification, the term "diffractive" is used throughout to differentiate prior art holographic technology used for 3-D image generation from diffractive technology necessary for the generation of a storage medium. For example, diffraction efficiency is critical to the viability of any material to be used as a diffractive storage medium. The quality of interference constituting a 3D-hologram is simple to achieve compared to the quality required to realize a storage medium. Moreover, a storage diffractive pattern can also be implemented by using other techniques than the interference of a reference and object beam, such as using as an e-beam etched on a material to generated diffraction patterns. For all these reasons, the specification herein introduces the concept of a broader diffractive optics technology.

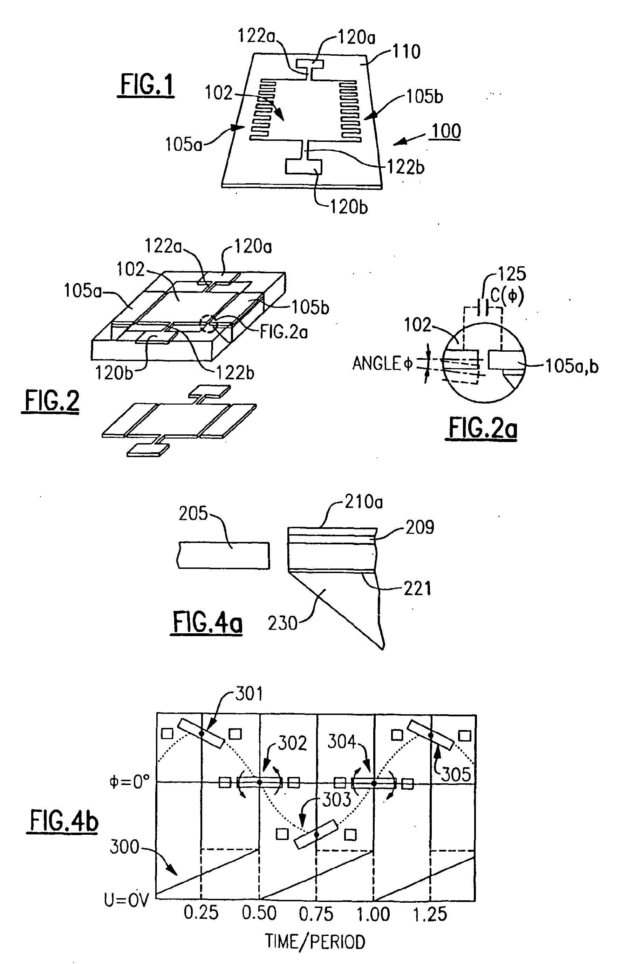

FIG. 1 shows a top view of a scanning micro-mirror element 100 comprising a mirror plate 102 suspended by two or four torsional springs 122a, 122b which connect the mirror plate 102 to anchors 120a, 120b, respectively. The anchors 120a, 120b are attached to the substrate 110. The two comb like driving electrodes 105a, 105b create torque to move the mirror plate 102. The mirror plate 102 of FIG. 1 is an example of a microoptoelectromechanicalsystem (MOEMS). A MEOMS is a system which combines electrical and mechanical components, including optical components, into a physically small size.

FIG. 2 shows a perspective view of the micro-mirror element 100 comprising the mirror plate 102 cut in a silicon substrate on which a reflected film is deposited, typically a film of aluminum with a typical thickness of about fifty nanometers. The plate 102 is suspended from the two or four twisting points 120a, 120b and is actuated by the two or four drive electrodes 105a, 105b, depending on whether it is desired to have the mirror 102 rotates in one or two directions. The angle of deflection is in theory unlimited, but in practice it is about 60°.

The variation of the capacitance C 125 (C varies with angle $\phi$) between the mirror plate 102 and the comb like driving electrodes 105a, 105b is used to generate the plate tortional movement. If a voltage U is applied by an energy source (not shown) to the driving electrodes 105a, 105b, the generated electrostatic torque M is:

$$M = 1/2 \ dC/d\varphi \ U^{\,2}$$

where $\phi$ is the deflection angle of the plate.

The mirror plate 102 can have a size from .5 x .5 mm up to 3 x 3 mm. The actuators (the movement between mirror plate 102 and electrodes 105 as driven by the energy source) are resonantly excited, i.e., they are continuously oscillating. The scan frequency depends on the size of the mirror plate (0.14KHz up to 20KHz) and a mechanical scan angle of $\pm 15°$ can be achieved at a driving voltage of only 20V.

When the actuator works in synchronous mode, it is possible to control the angular position of the mirror plate 102 by controlling the maximum deflection amplitude and oscillating period. Advantages of these mirrors is that the amplitude of the deflection can be monitored with the driving voltage U. For a large scan angle, the deflection angle varies linearly with the excitation voltage.

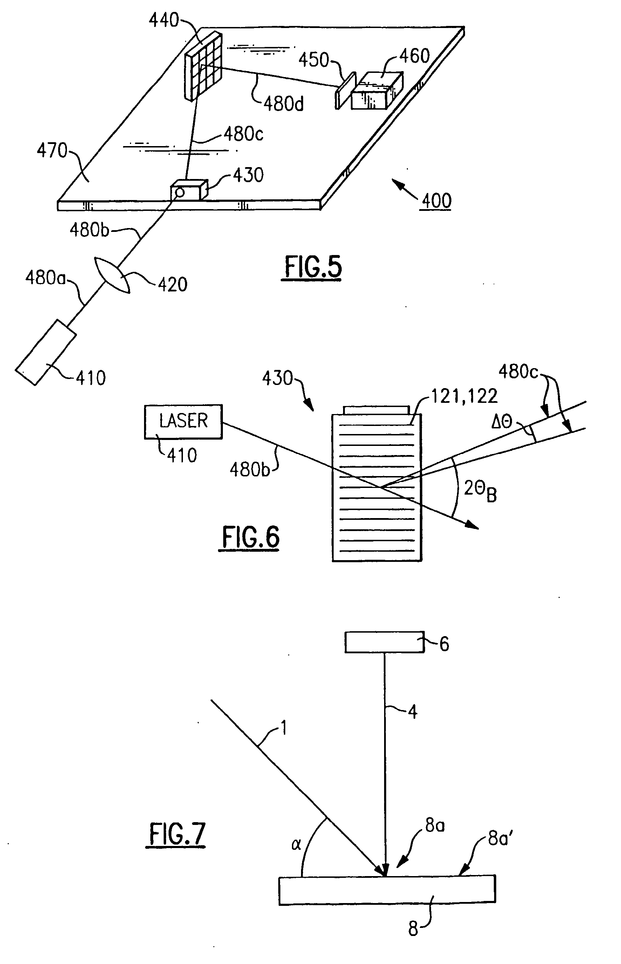

As shown in FIG 2A, the space lying between the mirror plate 102 and the drive electrodes 105a, 105b forms a variable capacitor. Thus, applying a voltage generates electrostatic torque acting on the plate and causing it to rotate and/or oscillate. Given the particularly small size of these micro-mirrors on the one hand, but also their mode of operation on the other, it becomes possible to reduce the size of the read device 400 (see FIG. 5) significantly and hence achieve a very high level of integration.

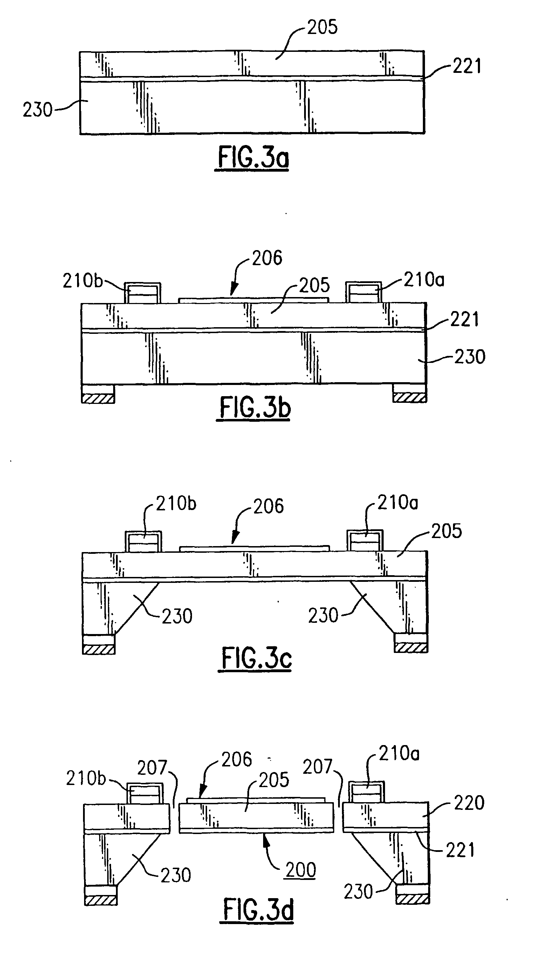

FIGs. 3a-3d show the process for manufacturing a micro-mirror element 200 on a substrate 230 with starting electrodes 210a, 210b. The fabrication is achieved using a CMOS-compatible technology. Referring to FIG. 3a, a wafer 230 serves as the base material. A buried oxide (BOX) layer 221 is produced in a SIMOX (Separation by Implantation of Oxygen) process. A 200-nm-thick silicon layer 205 on top of the BOX 221 is strengthened by a 20 um thick epitaxial layer. Referring to FIG. 3b, an oxide and a metal layer are deposited and patterned to form the starting electrodes 210a, 210b. The metal layer is protected by an additional oxide. In the next step a 50-nm-thick layer 206 of Al is deposited forming the reflective coating in the mirror area. Referring to FIG. 3c., the substrate underneath the designed torsional springs and the mirror plate 205 is removed by an anisotropical etch in a tetramethylammonium hydroxide (TMAH) solution leaving the remaining portions 230. TMAH is a chemical solution used for antisotropical etching of the wafer substrate in which the micro mirrors are etched. After that the BOX layer is removed and the epitaxial layer is patterned using the Advanced Silicon Etch™-process, trenches 207 are formed. A cross section of the micro-mirror chip 200 at the end of the process is shown in Figure 3d.

FIG. 4a illustrates the operation of the micro-mirror element 100. FIG. 4a shows the starting electrodes 210a used to start a motion of the mirror plate 205. A voltage of a fixed frequency is applied on the starting electrode 210a which yield asymmetries. Assuming perfect symmetry of the actuator it is impossible to start the oscillation without external induced forces. Therefore, there is an additional starting electrode 210a, 210b which is located on top of each of the driving electrodes 221 and isolated from it by an oxide 209. These electrodes 210a, 210b can be contacted separately and break the symmetry of the configuration. Once oscillation is initiated, the mirror actuation works in a synchronized mode where the mirror plate 205 oscillates in phase with the driving excitation of the voltage U generated by an energy source.

FIG. 4b shows synchronization of the mirror plate 102 as driven by a saw tooth signal 300. The saw tooth signal 300 comprises the voltage U applied with a predetermined frequency per second. The operation of the mirror plate 102 is shown at five different positions 301-305 as the mirror plate 102 is driven by saw tooth wave 300 applied across the drive electrodes 105a, 105b (see FIG. 1). In a full cycle comprising a movement from a positive angle, to zero degrees, to a negative angle, the mirror element 102 moves from positions 301 to 304 (a full cycle) and then begins the cycle again at position 305.

Table 1 shows the eigenfrequency (resonance frequency) of the micro-mirror element 100 as a function of mirror size. The eigenfrequency depends on the mechanical and electrical characteristics of the micro-mirror element 100. In the synchronized mode, the mirror oscillates at two times the eigenfrequency.

Table 1

| 1D Mirror size (mm) | 0.5 | 1 | 1.5 | 2 | 3 |
|---|---|---|---|---|---|
| Resonance frequency (Khz) | 2.32 | 0.4 - 7.5 | .25 - 2.5 | .14 - 1.5 | .2 |

FIG. 5 shows a reading system 400 comprising a separate unit on a platform 470 supporting an acousto-optic deflector 430, a microoptoelectromechanical systems (MOEMS) matrix 440, a matrix memory 450, and an image sensor 460, such as a CCD (charge-coupled device) detection system or other such image detection system. Additional devices located on or off the platform 470 comprise a light source 410 (e.g., a laser, laser diode) and a converging lens 420.

The operation of the reading system proceeds with the light source 410 emitting a light beam 480a which is focused by the converging lens 420 from a plane wave to spherical wave 480b. The spherical wave 480b is a convergent beam. The convergent beam 480b is deflected by the acousto-optic deflector 430 to form beam 480c which impinges on one of the micro-mirror elements of the MEOMS matrix 440. The MEOMS mirror matrix 440 has a size that fits the constraints of the memory matrix addressing system. The matrix of micro-mirrors 440 is used to address the matrix of points of the memory 450 in which data are recorded by spatial and angular multiplexing. The beam 480c coming from the acousto-optic deflector 430 forms an area with a diameter that can fit within the diameter of each one of the mirror elements of the MEOMS matrix 440. Additionally, the memory matrix 450 is spatially adjusted in such a way that the size of the laser beam 480d fits exactly the size of every point of the memory matrix 450.

FIG. 6 shows the acousto-optic deflector 430 in greater detail. The acoustooptic (AO) deflector 430 directs the laser beam 480b at an angle to the micro-mirror array 440. When acousto-optical crystals are subjected to stress, especially by means of a transducer usually consisting of a piezoelectric crystal, they modify the angle of diffraction of the light and, in general, of the electromagnetic wave which passes through them in order to modify the value of the diffraction angle of the emerging beam 480c. Thus, modifying the actuating frequency of the piezoelectric transducer deflects the light beam 480b to form the light beam 480c at one of a plurality of angles.

Thus, as shown in FIG 6, the variations in orientation along OX and OY (referring to the rectilinear co-ordinates of FIG. 2) of the incident read beam 480b emanating from the low-power laser 410 are obtained by subjecting this beam to two acousto-optic components 121, 122. Consequently it may be understood that, by varying the vibration frequency of the piezoelectric crystal associated with the acousto-optic component(s), it becomes possible to modify, very rapidly, the desired orientation of the grating within the rows and columns of the data-carrying matrix 450. The limiting factor then becomes the response time of the mirror elements of the MEOMS matrix 440 which act on the angle of incidence of the read beam.

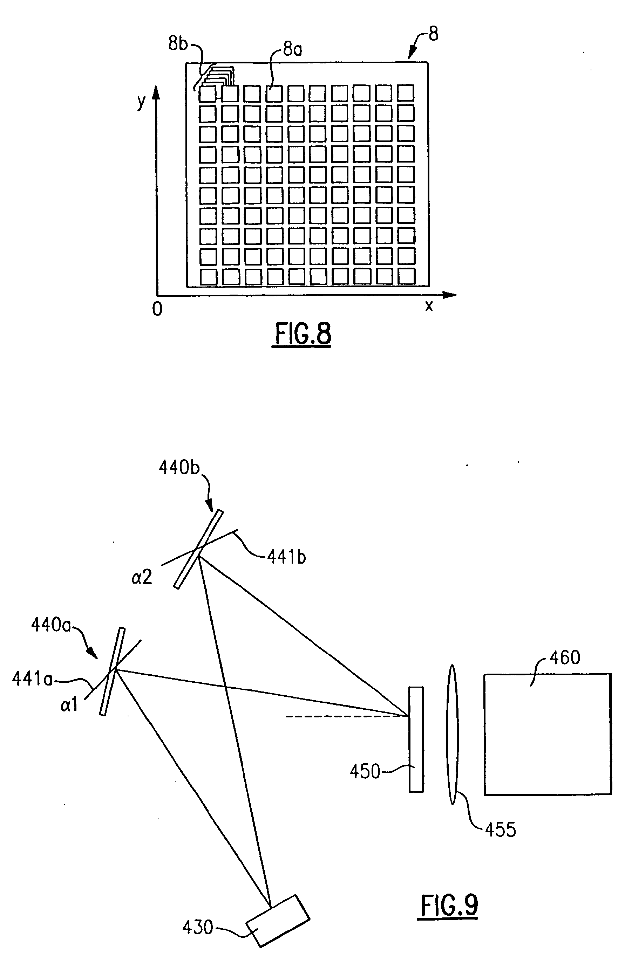

FIG. 7 and FIG. 8 describe the contents of the diffractive storage medium. Referring to FIG. 7, in forming a diffractive pattern, or alternately a hologram, a reference beam 1 intersects with an object beam 4 to form a sub-hologram 8a (referred to alternately as a point) extending through the volume of storage medium 8. There is a separate sub-hologram or point 8a extending through the volume for each angle and spatial location of the reference beam 1. The object beam 4 is modulated with a packet of information 6. The packet 6 contains information in the form of a plurality of bits. The source of the information for the packet 6 can be a computer, the Internet, or any other information-producing source. The hologram impinges on the surface 8a of the storage medium 8 and extends through the volume of the storage medium 8. The information for the packet 6 is modulated onto the storage medium 8 by spatial multiplexing and angle multiplexing. Angle multiplexing is achieved by varying the angle $\alpha$ of the reference beam 1 with respect to the surface plane of the storage medium 8. A separate packet 6 of information is recorded in the storage medium 8 as a sub-hologram for each chosen angle $\alpha$ and spatial location. Spatial multiplexing is achieved by shifting the reference beam 1 with respect to the surface of the storage medium 8 so that the point 8a shifts to another spatial location, for example point 8a', on the surface of the storage medium 8.

The storage medium 8 is typically a three-dimensional body made up of a material sensitive to a spatial distribution of light energy produced by interference of the object light beam 4 and the reference light beam 1. A hologram may be recorded in a medium as a variation of absorption or phase or both. The storage material must respond to incident light patterns causing a change in its optical properties. In a volume hologram, a large number of packets of data can be superimposed, so that every packet of data can be reconstructed without distortion. A volume (thick) hologram may be regarded as a superposition of three dimensional gratings recorded in the depth of the layer of the recording material each satisfying the Bragg law (i.e., a volume phase grating). The grating planes in a volume hologram produce change in refraction and/or absorption.

Several materials have been considered as storage material for optical storage systems because of inherent advantages. These advantages include a self-developing capability, dry processing, good stability, thick emulsion, high sensitivity, and nonvolatile storage. Some materials that have been considered for volume holograms are photorefractive crystals, photopolymer materials, and polypeptide material.

Referring now to FIG.8, there is shown in greater detail the storage medium 8 arranged in the form of a flat sheet, herein referred to as a matrix. In this example, the matrix is 1 cm$^2$. Each of a plurality of points on the matrix is defined by its rectilinear coordinates (x, y). An image-forming system (not shown) reduces the object beam 4 to the sub-hologram 8a having a minimum adopted size at one of the x, y point of the matrix. A point in physical space defined by its rectilinear coordinates contains a plurality of packets 8b.

In this case, a 1 mm$^2$ image 8a is obtained by focusing the object beam 4 onto the storage medium 8 centered at its coordinate. Due to this interference between the two beams 1,4, a diffractive image 8a 1 mm$^2$ in size is recorded in the storage material 8 centered at the coordinates of the matrix. Spatial multiplexing is carried out by sequentially changing the rectilinear coordinates. The object beam 4 focuses on the storage material 8 so that a separate image 8a is recorded at a unique position in the plane defined by its coordinates (x, y). This spatial multiplexing results in a 10 by 10 matrix of diffractive images 8a. Angle multiplexing is carried out by sequentially changing the angle of the reference beam 1 by means of the mirror elements of the MEOMS matrix 440. Angle multiplexing is used to create 15-20 packets of information 8b corresponding to 15 discrete variations of the angle of incidence of the reference beam. Additionally, it is possible to reach 20-25 packets by simple multiplexing and 40-50 packets by using double symmetrical angular multiplexing. A data packet is reconstructed by shinning the reference beam 1 at the same angle and spatial location in which the data packed was recorded. The portion of the reference beam 1 diffracted by the storage material 8 forms the reconstruction, which is typically detected by a detector array. The storage material 8 may be mechanically shifted in order to store data packets at different points by its coordinates (x, y).

FIG. 9 shows synchronization of the micro-mirrors 440. Because the micro-mirrors 440 are continuously oscillating, it is necessary to synchronize the acousto-optic deflector (AOD) 430 and the micro-mirrors 440 in order to realize the addressing of a data packet of the memory 450. By knowing mirrors parameters like amplitude of deflection and oscillating period, it is possible to control the switching time of the AOD 430. This way, one of the micro-mirrors can be accessed which addresses a desired position on the memory 450. The AOD 430 redirects the laser beam on a chosen mirror at a given time.

Two representative micro-mirrors 440a, 440b of the micro-mirror array 440 of FIG. 5 are shown with each of the micro-mirrors at a different position. The rest position 441 a is shown for the micro-mirror 440a. The rest position 441 b is shown for the micro-mirror 440b. The coherent laser beam is directed by the AOD 430 at different times to one of the micro-mirrors 440a, 440b which reflect the light beam at a predetermined location and angle to the memory 450. The lens 455 focuses the light energy onto the CCD array 460. A CPU (not shown), such as a computer, microcontroller, or other such control device, controls the AOD 430, the micro-mirrors 440, and the CCD detector 460. The CPU (not shown) receives inputs from sensors indicating the positions of the micro-mirrors 440a, 440b and receives inputs on the state of the AOD 430. The CPU (not shown) then controls the mirror positions of the micro-mirrors 440 and the deflection angle of the AOD 430. Synchronization of the micro-mirrors 440 with the AOD 430 is necessary to reach a maximum deflection angle. The maximum deflection angle is the maximum angle that can be reached by the processed beam. This means that the output beam of the acousto-optic device can reach a maximum value. Between the positive and negative value of this maximum will lie the angular range of the acousto-optic device. An other advantage of synchronization is that the maximum deflection can be monitored by the driving voltage control . That is, the deflection varies linearly with the driving excitation voltage U.

FIG. 9 illustrates synchronization between the micro-mirrors 440, the AOD 430 and the CCD camera 460. The synchronization is shown for two of the micro-mirrors 440a, 440b of the micro-mirror array 440. Because the micro-mirrors 440a, 440b are continuously oscillating at low frequencies (i.e., 200Hz), the micro-mirrors 440a, 440b can be considered as fixed mirrors compared to the switching time of the AOD (10 to 100 $\mu$ s). At a switching time T, the micro-mirrors positions can be monitored so that the it is determined how to access a specific packet of information from the memory 450. In the present invention, the CPU (not shown) controls the mirror synchronization and calculates the switching time of the AOD 430 and the CCD 460 to read a given packet of the memory 450. The positions of the micro-mirrors 440 are calculated to address every packet of the memory 450. At a time T1, the AOD 430 is switched to address the micro-mirror 440a to read a packet of the memory 450. At another time T2, the AOD 430 is switched to address the micro-mirror 440b to read a packet of the memory 450. The micro-mirror 440a is shown at an angle $\alpha$1 from the normal position 441 a. The micro-mirror 440b is shown at an angle $\alpha$2 from the normal position 441 b. The lens 455 focuses the output waveform carrying the data packets onto the array of the CCD camera 460.

The present invention is not to be limited in scope by the specific embodiments described herein. Indeed, various modifications of the present invention, in addition to those described herein, will be apparent to those of skill in the art from the foregoing description and accompanying drawings.

**Claims**

1. A solid-state apparatus (400) for reading information from a photonics diffractive memory (450), comprising:

   a coherent light source (410) configured to generate a convergent light beam (480b) ;
   an acousto-optic deflector (430) configured to deflect said convergent light beam (480b) ;
   a MOEMS matrix (440) of micro-mirrors configured to receive said deflected light beam (480c) from said acousto-optic deflector (430) at one of said micro-mirrors ;
   a photonics diffractive matrix memory (450) having a plurality of points configured to receive at one of said points said reflected light beam (480d) which is reflected from said micro-mirror ; and
   a detector (460) having a plurality of light-detecting cells, at least one of said cells receiving a portion of said reflected light beam (480d) transmitted through said point.

2. The apparatus (400) of claim 1, further comprising:

   a lens (420) for forming said convergent light beam (480b) from said light source (410).

3. The apparatus (400) of claim 1, further comprising:

   said convergent light source (410) is selected from the group consisting of a low power laser and a light-emitting diode.

4. The apparatus (400) of claim 1, wherein said detector (460) is a CCD detector array.

5. The apparatus (400) of claim 1, wherein each of said plurality of points stores one or more diffraction patterns.

6. The apparatus (400) of claim 1, wherein said photonics diffractive memory (450) comprises stored therein information located at said plurality of points of said memory (450) and at a plurality of angles at each one of said points so as to form a plurality of packets of information at each one of said points.

7. The apparatus (400) of claim 1, wherein each of said micro-mirrors is an oscillatory scanning micro-mirror.

8. The apparatus (400) of claim 7, further comprising:

   a computer configured to coordinate the synchronization of said acousto-optic deflector (430) and said oscillatory micro-mirrors so that said reflected light beam (480d) is directed to one of said points for a sufficient time to retrieve information from said point.

9. The apparatus (400) of claim 1, wherein each of said micro-mirrors is an oscillatory micro-mirror and the oscillation cycle of said micro-mirror is coordinated with the scanning of said acousto-optic deflector (430) so as to direct said reflected light beam (480d) onto one of said points of said storage medium (450).

**10.** A solid-state method for reading information from a photonics diffractive memory (450), comprising:

generating a light beam (480a) ;
converging said light beam (480a);
deflecting said convergent light beam (480b) by an acousto-optic deflector (430) towards a MOEMS matrix (440) of micro-mirrors ;
reflecting from one of said micro-mirrors said convergent light beam (480c) received from said acousto-optic deflector (430) to a photonics diffractive memory (450) comprising a plurality of points ; and
detecting a portion of said reflected light beam (480d) carrying information from one of said points illuminated by said reflected light beam (480d).

**11.** The method of claim 10, further comprising:

a lens (420) for forming said convergent light beam (480b) from said light source (410).

**12.** The method of claim 10, wherein said convergent light source (410) is selected from the group consisting of a low power laser and a light-emitting diode.

**13.** The method of claim 10, wherein said detecting is accomplished with a CCD detector array.

**14.** The method of claim 10, wherein each of said plurality of points stores at least one diffraction pattern.

**15.** The method of claim 10, wherein said photonics diffractive memory (450) comprises stored therein information located at said plurality of points of said memory (450) and at a plurality of angles at each one of said points so as to form a plurality of packets of information at each one of said points.

**16.** The method of claim 10, wherein each of said micro-mirrors is an oscillatory scanning micro-mirror.

**17.** The method of claim 16, further comprising:

co-ordinating the synchronization of said acousto-optic deflector (430) and each of said oscillatory micro-mirrors so that said reflected light beam (480d) is directed to one of said points for a sufficient time to retrieve information from said point.

**18.** The method of claim 10, wherein each of said micro-mirrors is a oscillatory micro-mirror and the oscillation cycle of said micro-mirror is coordinated with the scanning of said acousto-optic deflector (430) so as to direct said reflected light beam (480d) onto one of said points of said memory (450).

**Patentansprüche**

**1.** Festzustandsvorrichtung (400) zum Auslesen von Informationen aus einem Photonendiffraktionsspeicher (450), aufweisend:

eine kohärente Lichtquelle (410), die dafür ausgelegt ist, einen konvergenten Lichtstrahl (480b) zu erzeugen;
einen akusto-optischen Deflektor (430), der dafür ausgelegt ist, den konvergenten Lichtstrahl (480b) abzulenken;
eine MOEMS-Matrix (440) aus Mikrospiegeln, die dafür ausgelegt ist, den abgelenkten Lichtstrahl (480c) vom akusto-optischen Deflektor (430) an einem der Mikrospiegel zu empfangen;
einen Photonendiffraktionsspeicher (450) mit einer Vielzahl von Punkten, der dafür ausgelegt ist, an einem der Punkte den reflektierten Lichtstrahl (480d), der von dem Mikrospiegel reflektiert wird, zu empfangen; und
einen Detektor (460) mit einer Vielzahl von Lichterfassungszellen, wobei mindestens eine der Zellen einen Teil des reflektierten Lichtstrahls (480d), der durch den Punkt hindurch übertragen wird, empfängt.

**2.** Vorrichtung (400) nach Anspruch 1, ferner aufweisend:

eine Linse (420) zum Formen des konvergenten Lichtstrahls (480b) von der Lichtquelle (410).

**3.** Vorrichtung (400) nach Anspruch 1, ferner aufweisend:

die konvergente Lichtquelle (410), die ausgewählt ist aus der Gruppe bestehend aus einem Niedrigenergielaser und einer Licht emittierenden Diode.

4. Vorrichtung (400) nach Anspruch 1, wobei der Detektor (460) eine CCD-Detektorgruppe ist.

5. Vorrichtung (400) nach Anspruch 1, wobei jeder der vielen Punkte ein oder mehrere Diffraktionsmuster speichert.

6. Vorrichtung (400) nach Anspruch 1, wobei im Photonendiffraktionsspeicher (450) Informationen gespeichert sind, die sich an der Vielzahl von Punkten des Speichers (450) und an einer Vielzahl von Winkeln an jedem der Punkte befinden, um eine Vielzahl von Informationspaketen an jedem der Punkte zu bilden.

7. Vorrichtung (400) nach Anspruch 1, wobei jeder der Mikrospiegel ein oszillierender Abtast-Mikrospiegel ist.

8. Vorrichtung (400) nach Anspruch 7, weiter aufweisend:

einen Computer, der dafür ausgelegt ist, die Synchronisation des akusto-optischen Deflektors (430) und des oszillierenden Mikrospiegels zu koordinieren, so dass der reflektierte Lichtstrahl (480d) ausreichend lang auf einen der Punkte gerichtet wird, um Informationen von diesem Punkt abzurufen.

9. Vorrichtung (400) nach Anspruch 1, wobei jeder der Mikrospiegel ein oszillierender Mikrospiegel ist und der Oszillationskreis des Mikrospiegels mit der Abtastung des akusto-optischen Deflektors (430) koordiniert wird, um den reflektierten Lichtstrahl (480d) auf einen der Punkte des Speichermediums (450) zu richten.

10. Festzustandsverfahren zum Auslesen von Informationen aus einem Photonendiffraktionsspeicher (450), umfassend:

Erzeugen eines Lichtstrahls (480a);
Konvergieren des Lichtstrahls (480a);
Ablenken des konvergenten Lichtstrahls (480b) durch einen akusto-optischen Deflektor (430) in Richtung auf eine MOEMS-Matrix (440) aus Mikrospiegeln;
Reflektieren des konvergenten Lichtstrahls (480c), der von dem akusto-optischen Deflektor (430) empfangen wird, von einem der Mikrospiegel auf einen Photonendiffraktionsspeicher (450), der eine Vielzahl von Punkten aufweist; und
Erfassen eines Abschnitts des reflektierten Lichtstrahls (480d), der Informationen von einem der Punkte, die von dem reflektierten Lichtstrahl (480d) beleuchtet werden, trägt.

11. Verfahren nach Anspruch 10, ferner umfassend:

eine Linse (420) zum Formen des konvergenten Lichtstrahls (480b) von der Lichtquelle (410).

12. Verfahren nach Anspruch 10, wobei die konvergente Lichtquelle (410) ausgewählt wird aus der Gruppe bestehend aus einem Niedrigenergielaser und einer Licht emittierenden Diode.

13. Verfahren nach Anspruch 10, wobei die Erfassung mit einer CCD-Detektorgruppe durchgeführt wird.

14. Verfahren nach Anspruch 10, wobei jeder der vielen Punkte mindestens ein Diffraktionsmuster speichert.

15. Verfahren nach Anspruch 10, wobei im Photonendiffraktionsspeicher (450) Informationen gespeichert sind, die sich an der Vielzahl von Punkten des Speichers (450) und an einer Vielzahl von Winkeln an jedem der Punkte befinden, um eine Vielzahl von Informationspaketen an jedem der Punkte zu bilden.

16. Verfahren nach Anspruch 10, wobei jeder der Mikrospiegel ein oszillierender Abtast-Mikrospiegel ist.

17. Verfahren nach Anspruch 16, ferner umfassend:

Koordinieren der Synchronisation des akusto-optischen Deflektors (430) und jedes der oszillierenden Mikrospiegel, so dass der reflektierte Lichtstrahl (480d) ausreichend lang auf einen der Punkte gerichtet wird, um Informationen von dem Punkt abzurufen.

**18.** Verfahren nach Anspruch 10, wobei jeder der Mikrospiegel ein oszillierender Mikrospiegel ist und der Oszillationskreis des Mikrospiegels mit dem Abtasten des akusto-optischen Deflektors (430) koordiniert wird, um den reflektierten Lichtstrahl (480d) auf einen der Punkte des Speichers (450) zu richten.

**Revendications**

**1.** Un appareil tout solide (400) pour la lecture d'information à partir d'une mémoire à diffraction photonique (450) comprenant :

- une source de lumière cohérente (410) configurée pour générer un faisceau de lumière convergent (480b) ;
- un déflecteur acousto-optique (430) configuré pour défléchir ledit faisceau de lumière convergent (480b) ;
- une matrice de micro-systèmes opto-électro-mécaniques (MOEMS) (440) de micro-miroirs configurée pour recevoir ledit faisceau de lumière défléchi (480c) à partir dudit déflecteur acousto-optique (430) au niveau de l'un desdits micro-miroirs ;
- une mémoire matricielle à diffraction photonique (450) présentant une pluralité de points configurée pour recevoir à l'un desdits points, ledit faisceau de lumière réfléchi (480d) qui est réfléchi à partir dudit micro-miroir ; et
- un détecteur (460) présentant une pluralité de cellules de détection de la lumière, au moins une desdites cellules recevant une partie dudit faisceau de lumière réfléchi (480d) transmise à travers ledit point.

**2.** L' appareil (400) selon la revendication 1, comprenant en outre :

- une lentille (420) pour former ledit faisceau de lumière convergent (480b) à partir de ladite source de lumière (410).

**3.** L' appareil (400) selon la revendication 1, comprenant en outre :

- ladite source de lumière convergente (410) choisie parmi le groupe composé d'un laser basse puissance et d'une diode électroluminescente.

**4.** L' appareil (400) selon la revendication 1, dans lequel ledit détecteur (460) est une matrice de détecteurs de type CCD (dispositif à couplage de charge).

**5.** L' appareil (400) selon la revendication 1, dans lequel chacun parmi ladite pluralité de points mémorise un ou plusieurs motifs de diffraction.

**6.** L' appareil (400) selon la revendication 1, dans lequel ladite mémoire à diffraction photonique (450) comprend mémorisée en son sein de l'information située à ladite pluralité de points de ladite mémoire (450) et selon une pluralité d'angles au niveau de chacun desdits points afin de constituer une pluralité de paquets d'information au niveau de chacun desdits points.

**7.** L' appareil (400) selon la revendication 1, dans lequel chacun desdits micro-miroirs est un micro-miroir oscillant à balayage.

**8.** L' appareil (400) selon la revendication 7, comprenant en outre :

- un ordinateur configuré pour coordonner la synchronisation dudit déflecteur acousto-optique (430) et desdits micro-miroirs oscillants de sorte que ledit faisceau de lumière réfléchi (480d) soit dirigé vers l'un desdits points pendant un temps suffisant pour récupérer de l'information à partir dudit point.

**9.** L' appareil (400) selon la revendication 1, dans lequel chacun desdits micro-miroirs est un micro-miroir oscillant et le cycle d'oscillation dudit micro-miroir est coordonné avec le balayage dudit déflecteur acousto-optique (430) afin de diriger ledit faisceau de lumière réfléchi (480d) sur un desdits points dudit support de stockage (450).

**10.** Un procédé tout solide pour la lecture d'information à partir d'une mémoire à diffraction photonique (450), comprenant les étapes consistant :

- à générer un faisceau de lumière (480a) ;

- à faire converger ledit faisceau de lumière (480a);
- à défléchir ledit faisceau de lumière convergent (480b) au moyen d'un déflecteur acousto-optique (430) vers une matrice de micro-systèmes opto-électro-mécaniques (MOEMS) (440) de micro-miroirs ;
- à réfléchir au niveau de l'un desdits micro-miroirs ledit faisceau de lumière convergent (480c) reçu à partir dudit déflecteur acousto-optique (430) vers une mémoire à diffraction photonique (450) comprenant une pluralité de points ; et
- à détecter une partie dudit faisceau de lumière réfléchi (480d) portant de l'information à partir de l'un desdits points illuminés par ledit faisceau de lumière réfléchi (480d).

11. Le procédé selon la revendication 10, comprenant en outre :

- une lentille (420) pour former ledit faisceau de lumière convergent (480b) à partir de ladite source de lumière (410).

12. Le procédé selon la revendication 10, dans lequel ladite source de lumière convergente (410) est choisie parmi le groupe composé d'un laser basse puissance et d'une diode électroluminescente.

13. Le procédé selon la revendication 10, dans lequel ladite détection est réalisée au moyen d'une matrice de détecteurs de type CCD (dispositif à couplage de charge).

14. Le procédé selon la revendication 10, dans lequel chacun parmi ladite pluralité de points mémorise au moins un motif de diffraction.

15. Le procédé selon la revendication 10, dans lequel ladite mémoire à diffraction photonique (450) comprend mémorisée en son sein de l'information située à ladite pluralité de points de ladite mémoire (450) et selon une pluralité d'angles au niveau de chacun desdits points afin de constituer une pluralité de paquets d'information à chacun desdits points.

16. Le procédé selon la revendication 10, dans lequel chacun desdits micro-miroirs est un micro-miroir oscillant à balayage

17. Le procédé selon la revendication 16, comprenant en outre l'étape consistant :

- à coordonner la synchronisation dudit déflecteur acousto-optique (430) et de chacun desdits micro-miroirs oscillants afin que ledit faisceau de lumière réfléchi (480d) soit dirigé vers l'un desdits points pour un temps suffisant pour récupérer de l'information à partir dudit point.

18. Le procédé selon la revendication 10, dans lequel chacun desdits micro-miroirs est un micro-miroir oscillant et le cycle d'oscillation dudit micro-miroir est coordonné avec le balayage dudit déflecteur acousto-optique (430) afin de diriger ledit faisceau de lumière réfléchi (480d) sur un desdits points de ladite mémoire (450).

FIG.1

122a  120a  110
102
105b
105a  100
122b
120b

FIG.2

122a  120a
102
105a
105b
FIG.2a
120b  122b

125
C(φ)
102
ANGLE φ
105a,b
FIG.2a

205  210a
209
221
FIG.4a  230

FIG.4b

301
302  304
φ=0°
303
305
300
U=0V
0.25  0.50  0.75  1.00  1.25
TIME/PERIOD

12

FIG.3a

FIG.3b

FIG.3c

FIG.3d

**FIG.5**

**FIG.6**

**FIG.7**

FIG.8

FIG.9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5436867 A

- JP 11016375 A

**Non-patent literature cited in the description**

- **MILLER et al.** Micromachined electromagnetic scanning mirrors. *Opt. Eng.,* 1997, vol. 36 (5), 1399-1407

- **LAKNER et al.** Micromirrors for direct writing systems and scanners. *SPIE,* 1999, vol. 3878, 217-227
- Holographic Data Storage. Springer, 2000